# EUROPEAN PATENT APPLICATION

(11) **EP 1 850 482 A1**
(43) Date of publication of application: **31.10.2007**
(21) Application number: 07106183.2
(22) Date of filing: 13.04.2007
(51) Int. Cl.: H03K 17/96

(54) **Glass plate**

(30) Priority: 28.04.2006 EP 06113316
(71) Applicant: GLAVERBEL, 1170 Bruxelles (Watermael-Boitsfort) (BE)
(72) Inventor: Lefevre, Hugues, c/o Glaverbel, 6040 Jumet (BE); Jardinet, Alain, c/o Glaverbel, 6040 Jumet (BE)
(74) Representative: Farmer, Guy Dominic

(57) **Abstract**

A glass touch plate is used to provide a touch sensitive activator for a lighting circuit. The glass touch plate comprises a glass plate having a front, touch surface, an electrode arranged at the rear surface of the glass plate and a sensor adapted to detect, via the electrode, near proximity or touch with respect to the touch surface.

## Description

The present invention relates to a glass touch plate adapted to provide a touch sensitive activator for a lighting circuit.

Light switches commonly comprise a pivoting plastics plate within a fixed, surrounding plastics frame or border which the user moves between an on and an off position to turn the lights in a room on or off. It is known to construct such switches from flat glass sheets rather than plastics to provide a desired visual and/or tactile aspect to the light switch. In this case, both the pivoting plate and the border which surrounds the pivoting plate are cut out of flat sheets of glass and finished appropriately, for example by bevelling or smoothing the cut edges. This cutting and finishing operation can add significant manufacturing cost and delay particularly for the border which comprises a thin band of material often only a few millimetres wide, with its inside peripheral edge defining the orifice in which the pivoting plate of the light switch will be arrange.

One object of this invention is to provide an alternative way to use glass plates in light switches. Additional objective will become clear from the following description.

According to one aspect, the invention provides a glass touch plate as defined in claim 1. Addition aspects are defined in the other independent claims. The dependent claims define preferred and/or alternative embodiments.

One advantage of the invention with respect to the glass light switches described above is to provide an arrangement in which the glass touch plate is fixed rather than pivoting and which does not require the surrounding border of these known glass light switches.

Preferably the glass plate is opaque, that is to say non-transparent or translucent. This feature may be used to hide the electrode and/or other components from view. The glass plate may be a painted or coated glass plate, preferably with the paint or coating provided on the rear surface so that the touch surface is of glass. The paint or coating may cover an entire surface or substantially the entire surface of the glass plate, for example greater than 90%, 95% or 98% of the surface; it may be a continuous coating. An absence of discontinuities or gaps in the paint or coating as perceivable with the naked eye , particularly when illuminated from behind, may be used to provide an appearance of continuity and/or homogeneity.

The glass plate may be a coloured glass; the colouring may provide or contribute to the opaqueness.

The touch plate preferably comprises a single, monolithic glass plate.

The sensor may be adapted to detect a change in capacitance of the electrode, such a change being provoked by proximity of human contact, for example a hand or fingertip. The sensor may be a charge transfer touch sensor, for example a QT113 touch sensor marketed by Quantum Research Group Limited.

The configuration may incorporate an electrical screen or shroud to prevent undesired activation or detecting. This may be provided by providing the electrode with a central detection portion with a surrounding screening portion and arranging the configuration such that the screening portion acts to prevent undesired activation of the system, for example, by somebody moving their hand close to the glass touch plate rather that intentionally touching the central detection portion.

Arranging the sensor, and indeed other components, at the rear of the touch plate may provide a compact arrangement and facilitate manufacture and/or replacement if necessary of the electrical components on a single, compact circuit board.

The circuit board may be glued to the glass touch plate; it may be clipped; it may be either detachably or permanently attached.

A hermetic seal may be provided between the glass touch plate and a surface on which it is mounted, for example a wall. This may be in the form of a rubber or plastics seal positioned behind the touch plate between the wall and the rear surface of the touch plate, preferably hidden from external view. This may prevent ingress of dirt and/or water vapour and may enhance electrical safety, for example in a kitchen or bathroom environment.

The glass plate is preferably soda lime glass; it is preferably flat. It may have a thickness within the range of 1.8mm to 12.2 mm, typically of the order of 4mm, 5mm 6mm, 8mm or 10mm, and preferably in the range 1.8mm to 6.2mm.

Particularly in the case of the glass touch plate being provided as a stand alone switch, the surface area or the plate or the surface area of the detection portion of the plate may be within the range or 9 cm² to 225 cm², preferably greater than 12 cm² and preferably less than 100 cm².

Particularly in the case where the touch panel is provided as an integral portion of a glass panel, the surface area of the glass panel may be within the range or 900 cm² to 24 m², typically greater than 2400 cm² and typically less than10 m².

The touch surface is preferably of glass, notably uncoated glass; it may comprise or consist of an exposed glass surface.

The glass touch plate is particularly adapted for tuning lights on and off in domestic and office environments; it may be used in connection with a lighting control system that allows remote, automatic or centralised activation of lights.

The glass panel and/or the glass touch plate may be permanently attached to a supporting structure, for example by gluing; alternatively, a clip or other form of detachable attachment may be used.

An embodiment of the invention will now be further described, by way of example only, with reference to the accompanying drawing of which
FIG 1 is a schematic cross section of a glass touch plate light switch;
FIG 2a is a representation of part of an associated circuit provide on the underside of the circuit board;
FIG 2b is a representation of an associated electrode pattern provided on the top surface of the circuit board;
FIG 3 is a more detailed representation corresponding to FIG 2a;

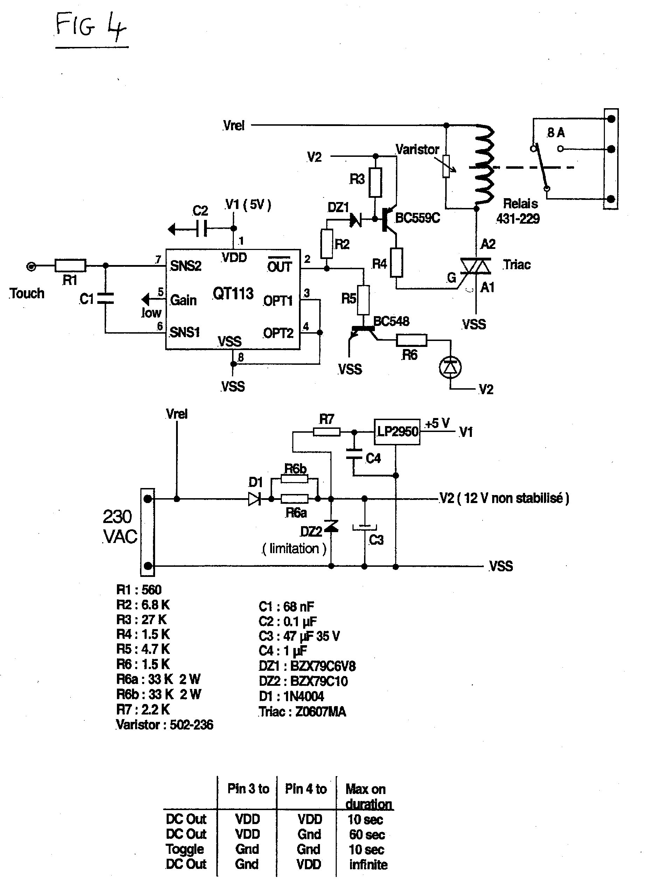

FIG 4 is a representation of another part of an associated circuit;
FIG 5 is a schematic representation of light switch provided as an integral part of a glass wall covering.

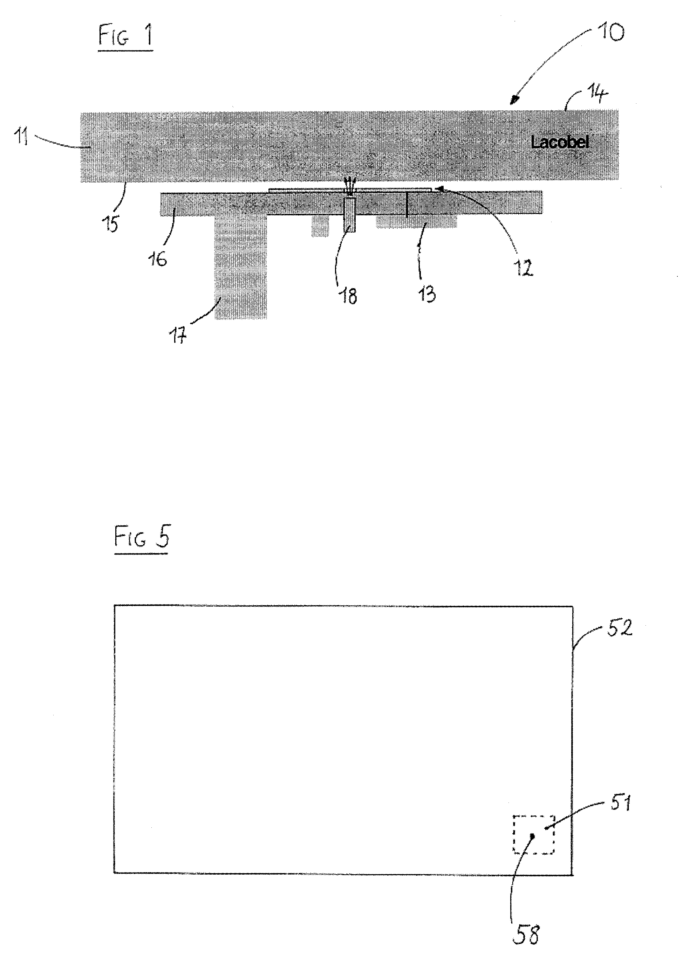

The glass touch plate 10 of FIG 1 comprises a fixed, non-moveable glass plate 11 with an electrode 12 and a sensor 13 arranged at the rear surface 15 of the glass plate. The front surface of the glass plate 14 provides a touch surface with the electrode 12 and sensor 13 being configured to detect near proximity to or touching of the touch surface by a user's hand so as to turn a light on or off.

The electrode 12 is provided on one side of a circuit board 16 proximate the rear surface of the touch plate 11 and connected to the sensor 13 which is arranged along with other components on the other side of the circuit board. Relay 17, controlled by the sensor 13, is adapted to switch a light on or off. An indicator 18 in the form of a LED provides a visual indication to the user of a central position of the touch plate 10. The circuit is configured such that if the relay is off, the LED is on; this provides a visualisation in the dark as to the position of the light switch.

The glass plate is a translucent, painted glass sheet having a layer of paint (not shown) covering its rear surface 15, preferably of the type sold by the applicant under the mark LACOBEL.

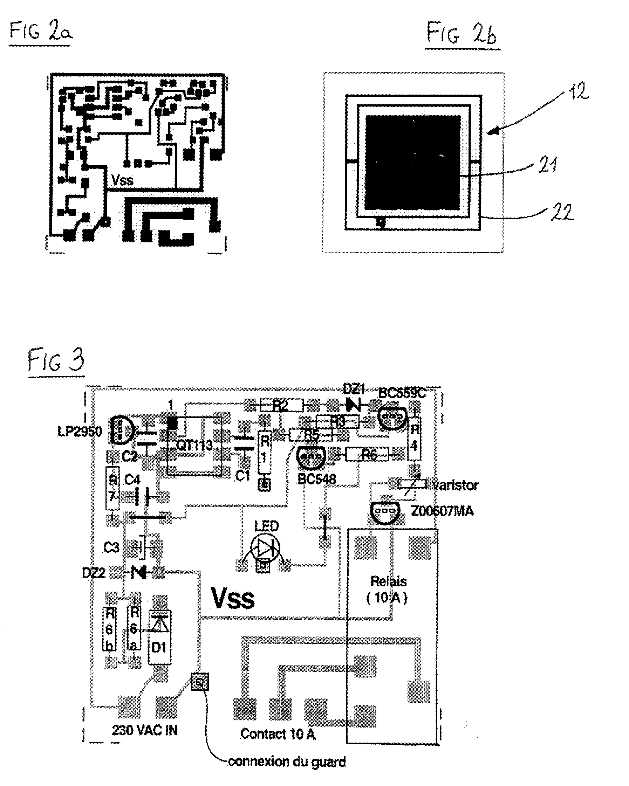

As shown in FIG 2, the electrode 12 comprises a central detection portion 21 surrounded by a screening portion 22.

The components and configuration of elements of the circuit are shown in the figures.

In the embodiment of FIG 5, the light switch 51 is provided as an integral part of a large glass wall covering 52. In this case, a LED indicator 58 may be arranged to permanently indicate a position at which the panel may be touched to turn a light on or off.

## Claims

1. A glass touch plate activator for a lighting circuit, **characterised in that** the glass touch plate comprises a glass plate having a front, touch surface, an electrode arranged at the rear surface of the glass plate and a sensor adapted to detect, via the electrode, near proximity or touch with respect to the touch surface.

2. A glass touch plate according to claim 1, wherein the glass plate is opaque.

3. A glass touch plate according to claim 2, wherein the electrode is hidden from view from the front surface of the glass touch plate by the opaque nature of the glass plate.

4. A glass touch plate according to any preceding claim, wherein the glass plate comprises an opaque coating, preferably a paint or lacquer, on its rear surface.

5. A glass touch plate according to any preceding claim, wherein the sensor is a capacitance based sensor, preferably a charge transfer sensor.

6. A glass touch plate according to any preceding claim, wherein the sensor is arranged at the rear surface of the touch plate.

7. A glass touch plate according to any preceding claim, wherein the arrangement comprises an illuminated indicator adapted to visually indicate the presence of the touch plate or a position on the touch surface susceptible to active the lighting circuit.

8. A glass touch plate according to claim 7 as dependent from claim 2, wherein the indicator comprises a light source, preferably a LED, arranged behind the glass touch plate and adapted to provide a visual indication that can be seen through the touch plate.

9. A glass touch plate according to any preceding claim, wherein the glass touch plate is provided as an integral portion of a glass panel, for example a sheet glass wall covering.

10. A glass touch plate according to any one of claims 1 to 9, wherein the glass touch plate is provided as a stand alone switch.

11. Use of a glass touch panel in accordance with any preceding claim as a light switch, particularly in a kitchen or bathroom environment.
